# EUROPEAN PATENT SPECIFICATION

(11) **EP 0 489 204 B1**
(45) Date of publication and mention of the grant of the patent: **16.08.1995**
(21) Application number: 90313127.4
(22) Date of filing: 04.12.1990
(51) Int. Cl.: G11C 16/06, G06F 9/445

(54) **Reprogrammable data storage device**
Wiederprogrammierbare Datenspeicherungsanlage
Support de données reprogrammable

(43) Date of publication of application: 10.06.1992
(73) Proprietor: Hewlett-Packard Limited, Bracknell, Berkshire RG12 1HN (GB)
(72) Inventor: Lloyd-Jones, Kevin, Bradley Stoke, Bristol, BS12 0BH (GB)
(74) Representative: Coker, David Graeme

(56) References cited:
- EP-A- 0 365 116
- WO-A-86/03328
- WO-A-89/10618
- GB-A- 2 227 584
- PATENT ABSTRACTS OF JAPAN, vol. 7, no. 121 (P-199)[1266], 25th May 1983; & JP-
- A-58 39 326
- IBM TECHNICAL DISCLOSURE BULLETIN, vol. 31, no. 3, August 1988, pages 491-492, Armonk, New York, US; "Format to hex code to object code with computed checksum"
- 8045 IEEE Spectrum, no.12, vol.26, December 1989, New York, US, pages 30-33, Pashley et al.: "Flash memories: the best of two worlds"

## Description

The present invention relates to a data storage device, such as a disc or tape storage device, which can be reprogrammed with new program code.

Data storage devices are known of the type comprising:
- input/output means for exchanging data between the device and an external data handling system;
- media read/write means for reading/writing data from/to a storage medium;
- a data buffer connected between the input/output means and the media read/write means for buffering the transfer of data between the input/output means and the media read/write means; and
- control and processing means connected to the input/output means, the data buffer and the read/write means, and operative to control the transfer of data via said data buffer between the input/output means and the read/write means and to process said data, said control and processing means including a non-volatile memory for holding program code and a program-controlled processor operative to execute said program code.

Typically, the data handling system will be a host computer while the media read/write means will be a magnetic-tape drive or a magnetic or optical disc drive.

With such data storage devices, there is a general need to match the rate of transfer of data to/from the external data handling system with the rate of transfer of data from/to the storage media. Furthermore, there is usually also a requirement to effect high-level reformatting of the data. It is for one or both these reasons, that such data storage devices are provided with a data buffer as the buffer can serve to smooth data flows and can also act a temporary store enabling the control and processing means to access the data for reformatting purposes.

The control and processing means will generally be microprocessor based with the controlling program code (the "firmware") being stored in a non-volatile memory either of the type referred as a ROM memory (Read Only Memory) or of the type referred to as EPROM memory (Electrically Programmable Read Only Memory).

Should it be desired to change the firmware for whatever reason, it has in the past been necessary to remove the ROM or EPROM chip (or chips) concerned and either replace them with new ones containing revised firmware or undertake a lengthy erasure and reprogramming process before replacing the chip. Not only is this time consuming, but for practical reasons it requires the memory chips to be socket mounted rather than being soldered direct to the circuit board carrying the chips; this in itself is disadvantageous as socket mounting chips is not only more expensive but also less reliable than using soldered connections.

The prior art document WO 86/03328 describes a data storage device using an EEPROM.

Recently, electrically erasable and reprogrammable non-volatile memories, known generically as "flash" memories, have become available such as the Intel 28F010 flash memory chip. These chips can be electrically erased (though only on a chip basis, not a byte basis) and then reprogrammed on a byte-by-byte basis. The concept of flash memories is described in prior art document IEEE Spectrum, no.12, vol.26, December 1989 New York, US, pages 30-33, Pashley et al.: "Flash memories: the best of two worlds".

Flash memory enables the firmware code of microprocessor-based equipment to be changed without physical removal of the chips. Instead, the new code is provided to the equipment to be programmed (in any appropriate manner) and this code is written direct to the flash memory, the latter having been erased at the start of the reprogramming process. Since the new code can be provided either electronically from a remote host computer or stored on a media that can be sent through the mail system, the need for a service engineer to be present to carry out reprogramming is effectively avoided, the whole operation now being capable of being carried out by an end user without undue difficulty.

However, a major problem arises if the transfer of the new firmware code should for any reason be unsuccessful at the first attempt (for example, due to a power failure, failure of the remote host, or failure of the storage media) since the original firmware that the equipment relied upon to initiate the reprogramming cycle of the equipment has been lost and the new firmware has not been fully installed. In these situations, the only recourse will normally be to call out a service engineer or to return the equipment for servicing. The period of vulnerability of the equipment during reprogramming is generally considerable due to the time taken to transfer all the new code to the equipment.

It is an object of the present invention to reduce the aforesaid problem.

According to the present invention, there is provided a data storage device of the aforesaid type, in which at least a portion of said non-volatile memory is a flash memory and the control and processing means is operative to implement the following steps in sequence for the purpose of reprogramming the flash memory with new program code:
a) storage of the new program code, received via said input/output means or said media read/write means, into said data buffer;
b) determination of when all said new program code has been received and stored in the data buffer;
c) erasure of said flash memory; and
d) transfer of the new program code from said data buffer to said flash memory.

By using the data buffer to accumulate all the new program code prior to erasing the flash memory, the period of vulnerability of the device is reduced since should the reprogramming process fail, for whatever reason, during the transfer of the new code to the device, then the device is still available for operation, albeit with the old program code rather than with the new code. Because the rate of transfer of data to the data buffer either from an external data handling system or from a storage media will generally be considerably less than the rate at which code can be copied across from the buffer to the flash memory, it can be seen that the reduction in the period of vulnerability of the device by use of the data buffer is substantial.

The program code used to effect steps (c) and (d) of the reprogramming process must, of course, reside elsewhere than in the flash memory, at least during the execution of these steps. This code could, for example, be run by a different processor to that associated with the flash memory, or the code could be stored, unmodifiable, in ROM for execution by the first processor; however, such approaches reduce the flexibility sought in the first place by providing for reprogrammability. One approach to providing the sought after flexibility would be to store the code for step (c) and (d) in the flash memory but to copy the code across to another rewritable memory (for example, a static RAM memory) associated with the processor prior to erasing the flash memory, and then having the processor execute the code from that other memory. Another approach would be to download the code for carrying out reprogramming steps (c) and (d) to a memory, such as a static RAM memory, of the control and processing means and then execute this code (with the processor associated with the flash memory, or another processor) to carry out steps (c) and (d).

Preferably, following a positive determination in step (b) of the reprogramming process and prior to executing step (c), the control and processing means effects a checking step in which one or more checks are carried out on the new program code held in the data buffer, the control and processing means only proceeding with steps (c) and (d) where the check results are satisfactory.

Advantageously, this checking step involves checking the new program code stored in the data buffer to ascertain whether any of the new program code has become corrupted since storage in the data buffer. For this purpose, the control and processing means can be arranged during step (a):
- to store parity data in respect of each byte or word of the new program code, and
- to generate progressively an error checking code by carrying out an exclusive OR function between each bit of the new program code as it is stored in the data buffer and another bit in said buffer, the resultant error checking code being stored in said buffer;

during the checking step the control and processing means is then arranged to regenerate said error checking code and said parity data to detect any errors and seek to effect correction of errors so detected.

Another check which is preferably effected concerns the compatibility of the new code and the device. This is possible where the flash memory holds identification data indicative of the identity of said program code and/or of said device, and the new program code also includes identification data indicative of the identity of the new program code and/or of the device on which the new program code is intended to run. In this case, the control and processing means can be arranged during the said checking step to compare the identification data held in the flash memory with that provided with the new program code to ascertain whether the new program code is compatible with said device.

Where the flash memory holds device operational parameters, the control and processing means is advantageously operative to transfer said device operational parameters to a temporary store (for example, the data buffer) prior to implementing step (c), and then subsequently to restore said parameters to the flash memory.

The control and processing means can be arranged during step (a) of the reprogramming process to calculate a checksum for the area of the buffer used to store the new program code, this checksum being recalculated as new program code is progressively stored in the buffer, the final checksum being loaded into the flash memory together with the new program code. The control and processing means can then be further arranged upon power up of the device to recalculate the check sum for the flash memory and compare it with the stored check sum to check the integrity of the program code stored in the flash memory.

A reprogrammable data storage device embodying the invention will now be described, by way of non-limiting example, with reference to the accompanying diagrammatic drawings, in which:
- Figure 1: is a block diagram of the data storage device;
- Figure 2A: is a flow chart illustrating the steps involved in transferring new firmware code from an external host to a data buffer of the data storage device;
- Figure 2B: is a continuation of the flow chart of Figure 2B illustrating the checking of the new firmware code and its transfer from the data buffer to a flash memory of the data storage device;
- Figure 3: is a diagram of the file format of an "Absolute File" in which the host initially provides the new firmware code; and
- Figure 4: is a diagram of the format of a data record of the Figure 3 Absolute File.

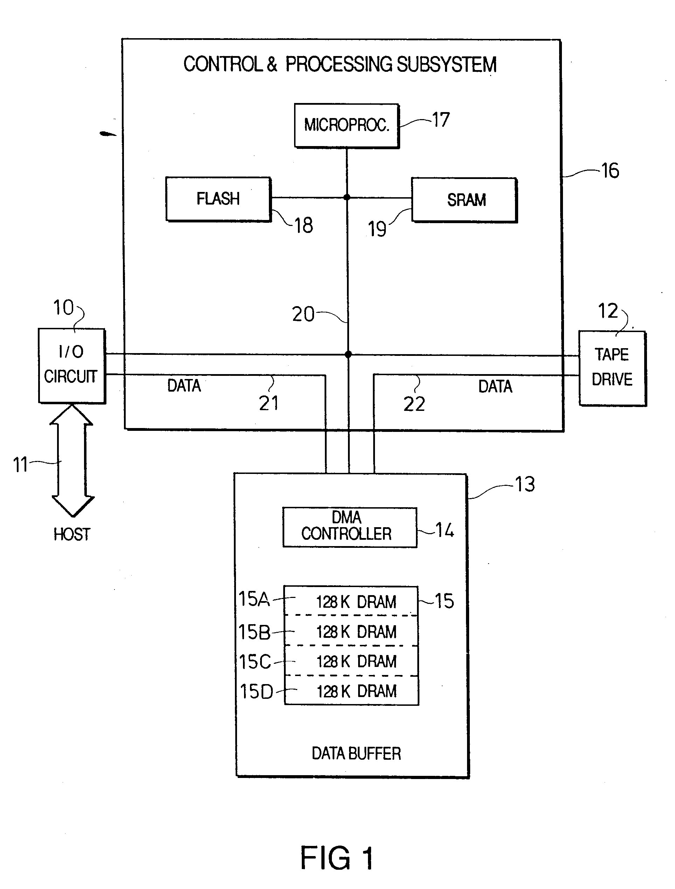

The data storage device shown in Figure 1 is intended to store data from a data handling system ( in the present case, a host computer) to a data storage medium (in the present case, a magnetic tape) and also to read data from tape back to the host computer. The host computer (not shown) is connected to an input/output circuit 10 of the storage device by a bus system 11. Communications over this bus system 11 will generally take place in accordance with a standard protocol such as the SCSI protocol with the protocol interactions over the bus system 11 being handled by the input/output circuit 10.

Data is written to tape and read back from tape by a tape drive sub-assembly 12 (including the mechanical drive deck, servo electronics and analog read/write electronics).

In addition to the input/output circuit 10 and tape drive 12, the data storage device comprises a data buffer 13 for buffering the transfer of data between the input/output circuit 10 and the tape drive 12, and a control and processing subsystem 16.

The data buffer 13 comprises, for example, 512K bytes of dynamic RAM memory 15 (shown notionally divided into four 128K byte segments), and a DMA controller 14 for controlling block transfers of data between the buffer 13 and the input/output circuit 10, the subsystem 16 and the drive 12. The DMA controller also serves to add a parity bit to each byte being stored in the memory 15 and to remove this bit from the byte before it is transferred out of the memory.

The subsystem 16 comprises a microprocessor 17, a non-volatile memory 18 (for example, 256K bytes) storing a control program ("firmware" code), and a static RAM memory 19. The function of the subsystem 16 is to control the overall operation of the data storage device. For this purpose, the bus system 20 of the microprocessor 11 extends to the input/output circuit 10, the buffer 13 and the tape drive 12. The subsystem 16 may also function to process (in particular, to reformat) data being stored and retrieved to/from tape; this processing is done by the microprocessor 17 by operating on the data in the buffer 13 via the bus system 20. The input/output circuit 10 and tape drive 12 are connected to the buffer 13 by bus systems 21 and 22 respectively.

During data storage, the subsystem 16 controls the input of data into the buffer 13 from the host computer via the bus system 11, the input/output circuit 10 and the bus system 21, and the subsequent transfer of data from the buffer to the tape drive 12 via the bus system 22. The buffer 13 permits the differing data rates and formats of the host system and tape drive to be matched to one another. The subsystem 16 may also perform a reformatting function between the reading in of data into the buffer 13 and the reading out of data to the tape drive 12. In implementing this function, the subsystem 16 is arranged to read data from the buffer 13 and write it back to the buffer in a different arrangement possibly with the addition of format control codes.

During data read back, the subsystem 16 oversees the reading in of data from the tape drive 12 into the buffer 13 via the bus system 22 and the subsequent reading out of that data from the buffer 13 to the host computer via the bus system 21, the input/output circuit 10 and the bus system 11. In addition, the subsystem 16 may effect a reverse formatting of the data held in the buffer 13 to that which was implemented during data storage.

In addition to the passage of data through the data storage device as described above, the subsystem 14 will exchange control signals with the host computer and the tape drive 12 via the corresponding bus systems.

It should be noted that the control and processing subsystem 16 may include additional processing elements. For example, a channel processor (not shown) may act on the data being passed between the buffer 13 and the tape drive 12 to effect low-level formatting additional to higher-level formatting effected by the processor 17. The channel processor may be a microprocessor-based system and include its own buffer memory (generally of a substantially smaller size than the buffer 13).

Data storage devices operating substantially as described are well known in the art and a more detailed description of the general operation of the illustrated device will not therefore be given herein. However, it may be noted that a preferred arrangement for the form and operation of the buffer 13 are described in our co-pending European Patent Application EP-A-0,365,116.

In the present data storage device, the non-volatile memory 18 storing the firmware code for the microprocessor 17 is a flash memory. Furthermore, in accordance with the present invention, the data storage device can be commanded to reprogram the memory 18 with new firmware code provided to the device either from the host computer via the input/output circuit 10 or on a tape media read by the tape drive 12.

Control of the reprogramming process within the data storage device is effected by the control and processing subsystem (in particular, by the microprocessor 17).

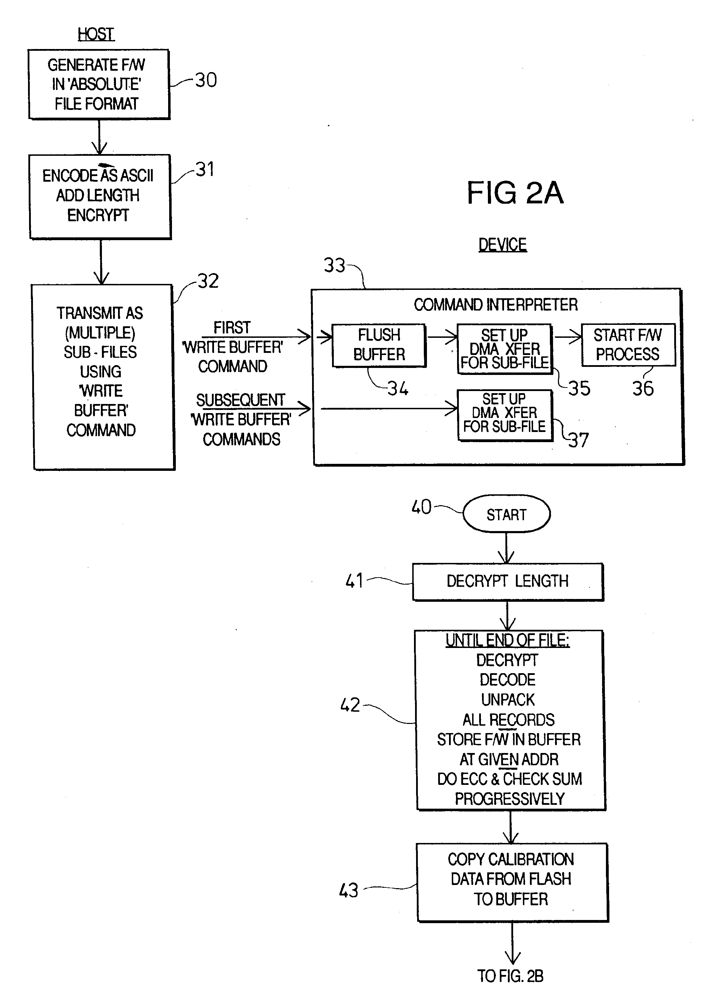

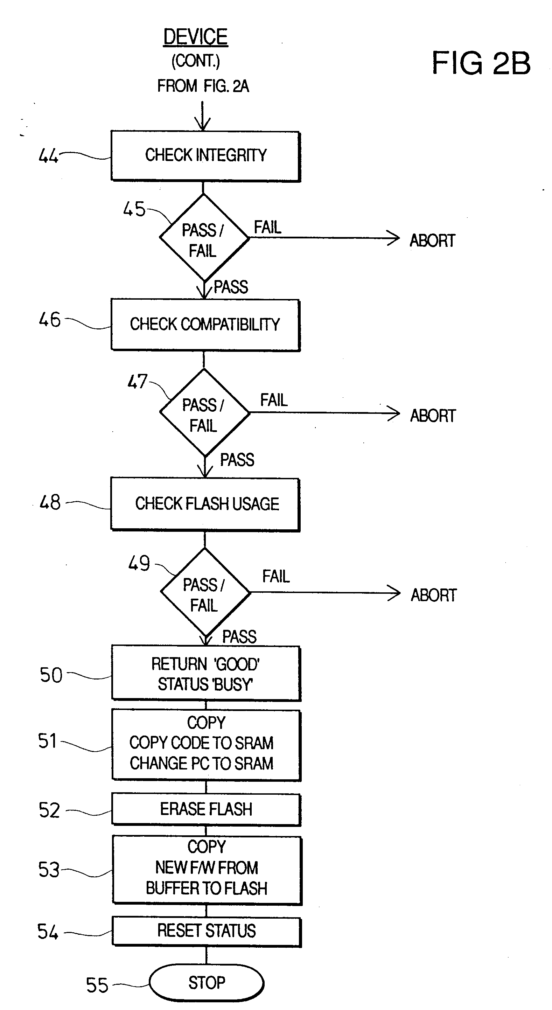

The overall reprogramming process is illustrated in Figures 2A and 2B with respect to new firmware code provided by the host computer. Figure 2A illustrates the process from generation of the new firmware code in the host computer to storage of the new code in the buffer 13 of the storage device, while Figure 2B illustrates the final part of the process in which the new code held in the buffer 13 is checked, followed by the flash memory 18 being erased and the new code being transferred into the flash memory 18.

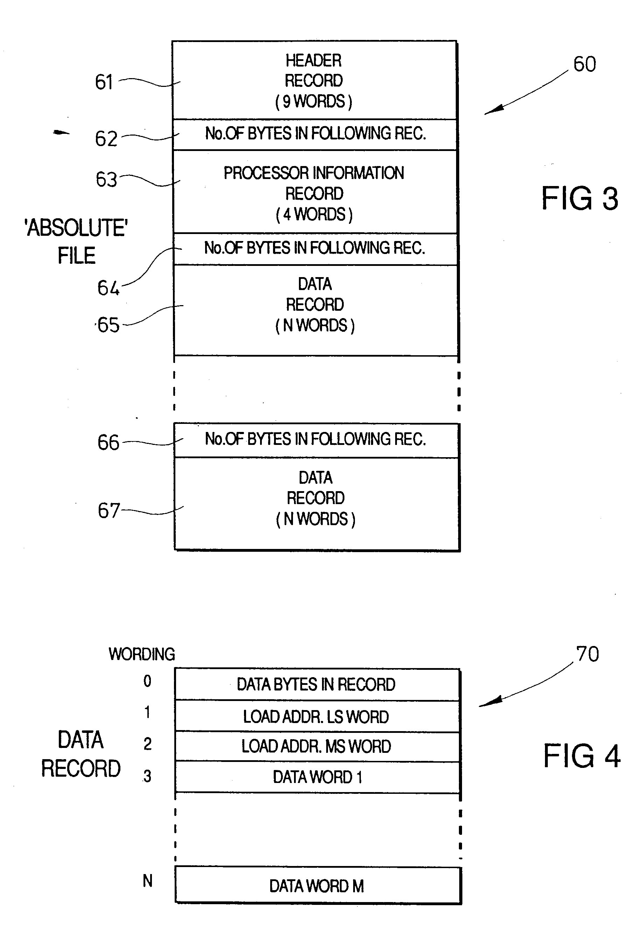

Referring to Figure 2A, the first step 30 of the reprogramming process is the provision of new firmware code in a standard file format, known as "Absolute File" format, which sets out not only the new code but also the intended locations in memory of the various segments of the code. Figure 3 illustrates the Absolute File format. An Absolute File 60 comprises a 9-word (2 bytes/word) header record 61, a 4-word processor information record 63, and a number of N-word data records 65, 67. Each of the processor information and data records 63, 65 and 67 is preceded by a word 62, 64 and 66 containing the number of bytes in the following record (this number will be a multiple of 2 since each record contains whole words). The header record and processor information record contain data identifying the code and providing certain information relevant to the target processor; the data records contain the new firmware code and the load addresses for this code.

Figure 4 illustrates the structure of a data record 17 of the Absolute File. The first word of the record (word "0") contains the number of data bytes in the record (this number may differ from that contained in the word preceding the record since the number in word "0" of the record indicates the number of bytes which contain useful information and this may be less than the length of the record which is of fixed length). The second and third words of the data record 70 (words "1" and "2") contain the least significant and most significant words of the load address in memory of the firmware code held in the data record. These load addresses are relative to the first address of the memory concerned. The remaining words of the data record (words "3" to "N") are available for storing firmware code though, in practice, not all of these words may be used for this purpose and some may be left unused; the number of bytes containing firmware code can be derived from the number contained in word "0" of the data record.

After the firmware has been embedded in an Absolute File, this file is then encoded as ASCII characters by taking each successive grouping of four bits and converting it into the corresponding hexa-decimal character ("0" to "F"). Thereafter, an 8-byte field is added to the front of the file indicating the total number of bytes in the file. Finally, the total package is subjected to a low-level encryption process to prevent it being tampered with by casual users; this encryption process is, for example, a simple substitution coding by which specified characters are substituted for other characters. The foregoing process forms step 31 in Figure 2A.

The resulting encoded and encrypted firmware file is then transmitted from the host to the data storage device. Since the size of this file may be of the order of 750k bytes after encoding and encryption, this file is first subdivided into a number of sub-files and each sub-file is then transmitted to the device. Where the host computer and the data storage device communicate with each other using SCSI commands, each sub-file is transmitted under a corresponding "Write Buffer" command which the device will understand as being a command to transfer a predetermined number of bytes following the command to its buffer. In the present case a "mode" field of the Write Buffer command is set to "mode 4" to indicate to the device that it is to use the data which it is being passed as new firmware code. The transmission of the firmware sub-files by the host is represented by block 32 of Figure 2A.

Each command received by the device is passed to the microprocessor 17 for interpretation by a command interpreter process 33. Upon receipt of the first mode-4 Write Buffer command, the processor initiates flushing of the buffer 13 (block 34) and then sets up the DMA controller 14 to transfer the firmware sub-file associated with the Write Buffer command into the buffer 13 (block 35). The necessary information concerning the length of the sub-file is contained in the Write Buffer command itself and the microprocessor 17 causes the sub-file to be written into the memory segment 15D of the buffer memory 15. The memory segment 15D is used during the transfer process as a temporary store for incoming firmware sub-file data. After setting up the DMA transfer, the command interpreter 33 then initiates a firmware upgrade process (see block 36).

Subsequent mode-4 Write Buffer commands received by the command interpreter 33 are treated somewhat differently by the command interpreter as it knows that a firmware update cycle is in progress; the command interpreter therefore simply sets up a DMA transfer for the sub-file associated with the command in order to store the incoming firmware sub-file data into the area 15D of the buffer memory 15.

As already noted, the area 15D of the memory 15 is simply used as a temporary store for incoming data, this data being almost immediately extracted under the control of the firmware upgrade process, and appropriately processed to produce an image of the desired firmware code in areas 15A and 15B of the memory 15 together with Error Correction Code (ECC) in area 15C of the memory 15.

The firmware update process itself is illustrated in Figures 2A and 2B as blocks 40 to 55. This process runs in parallel with the transfer of the sub-files to the buffer 13 and will suspend itself as necessary pending receipt of the next sub-file until all the sub-files have been received. Indeed, it is not necessary for the mode-4 Write Buffers commands and their associated sub-files to be sent in an uninterrupted sequence from the host to the data storage device and other commands may intervene in this sequence provided that these intervening commands do not require the destruction of the firmware code being built up in the buffer memory 15.

Upon start of the firmware upgrade process (block 40) the first 8 bytes of the first sub-file are decrypted to give the overall length in bytes of all the sub-files taken together (block 41). This decryption process is simply a reverse of the process used to encrypt the data in block 31. This total length figure is subsequently used to determine when all the new firmware code has been received by the data storage device.

Next, the firmware update process undertakes decryption and decoding of the sub-file data being passed into memory area 15D (this decryption and decoding being the reverse of the processes effected in block 31). The resultant data is firmware code data in Absolute File format and the microprocessor 17 then effectively unpacks the firmware data itself from this file format and stores the data in memory area 15A, B as indicated by the relative load addresses contained in the Absolute File.

At the same time as writing the firmware data into the buffer memory 15, the processor progressively generates an ECC code (Error Checking/Correction Code) and recalculates a checksum for the new firmware. All these steps are represented by block 42 of Figure 2A.

The ECC is generated by carrying out an exclusive OR function between corresponding bits of memory areas 15A and 15B with the result being stored in the corresponding area of 15C. This process is effected each time a bit is changed in one of the areas 15A or 15B (the process is, of course, only carried out on the changed bit and its counterpart in the other one of the areas 15B, A).

The checksum is calculated by treating the memory areas 15A and 15B as 64K four-byte words which are added together to form the checksum.

A check is also kept on the number of bytes processed from the memory area 15D and when this number equals the total byte length decoded in block 41, the processes of block 42 are terminated. As already indicated, the processes in block 42 are suspended in the event that all the data transferred into memory area 15D has been processed but the total byte count for that file has not been reached; in this case, the block 42 processes remain suspended until further data is received in the memory area 15D.

After all the new firmware code has been decrypted, decoded, unpacked and stored in the memory areas 15A and 15B, the firmware update process copies certain data known as "calibration" data from the flash memory 18 across to the corresponding locations in the buffer memory 15A and 15B. This calibration data may include certain operational parameters and set up data, manufacturers code, and usage information. The data held in memory areas 15A and 15B should now be an image of the full firmware code that it is desired to download into the flash memory 18.

Figure 2B illustrates the subsequent steps of the firmware update process in which the firmware code in the memory 15 is first subjected to a number of checks and is then transferred across to the flash memory.

In order to ensure that the firmware code held in the memory 15 has not become corrupted over the period during which it has been stored in the memory (which could be a considerable length of time), the integrity of the data held in the memory areas 15A and 15B is first checked (see block 44). This integrity check is effected by checking the parity bit of each byte and also by recalculating the ECC and checking it with the ECC stored in the memory area 15C. Should either of these checks indicate an error, then the code is failed (block 45) and the update process is aborted with an appropriate response being sent back to the host. However, if the code passes its integrity check, the firmware update process proceeds to the next check after storing the checksum in a predetermined location in the firmware image in memory area 15A, B.

This next check (block 46) concerns whether or not the firmware code stored in memory areas 15A, 15B is compatible with the storage device. To this end, identification data related to the drive and/or the code itself is associated with the firmware code, such identification data being present in the existing code held in the flash memory 18 as well as in the new code held memory 15. By comparing the identification data, the microprocessor 17 can tell whether or not the new code is compatible with the storage device. If the new code is incompatible (block 47) then the update process is aborted and the host appropriately informed. However, if the code is compatible, the update process proceeds to the next check.

The next check to be carried out is whether or not the number of reprogrammings of the flash memory 18 has reached the limit set for the device (typically 10,000 reprogrammings). The current number of reprogrammings is held in the calibration area of the flash memory 18 and provided the check in this number is satisfactory, this number is incremented and stored to the corresponding location in the memory areas 15A and 15B. If, however, the number of reprogrammings has reached the limit value, then the update process is aborted (block 49) and the host is appropriately informed.

After all the checks 44, 46, and 48 have been carried out and satisfactorily passed, a corresponding indication ("good") is returned from the storage device to the host and the device is then set "busy" for the duration of the subsequent steps of the update process, these being the key steps when the device becomes vulnerable. During this period, any attempt by the host to communicate with the storage device will be met with a "busy" response.

It will be appreciated that up to this point in the firmware update process, the original firmware in the flash memory 18 has remained intact so that any failure in the process would have been non-catastrophic and would simply have required reinitiation of the overall reprogramming cycle. However, now that all the new firmware code has been stored in the buffer memory 15 and checked, it is next necessary to erase the flash program 18 of the existing firmware code and transfer the new code across. Of course, before this can be done, code for controlling the microprocessor 17 during the erasure and copying process must be made available. In the present case, this code is available in the flash memory 18 but must, of course, be copied from this memory to a location where it is available after erasure of the memory 18. Thus, the relevant code is copied from the flash memory 18 into the static RAM memory 19 associated with the microprocessor 17 (see block 51). The program counter of the microprocessor 17 is correspondingly changed so that the rest of the firmware update code is read from the RAM 19.

Next, the flash memory 18 is erased en bloc (see block 52).

Thereafter, the new firmware code held in memory areas 15A and 15B is programmed into the corresponding locations in the flash memory 18 (see block 53). During this process, the parity of each byte is rechecked and the ECC recalculated and compared with the stored ECC. Should either of these checks indicate an error, then an attempt is made to correct the error. Thus, for example, if a byte in memory area 15A is shown to be errored by the checking of its parity bit but the corresponding byte in memory area 15B passes its parity check, then the corresponding ECC bits can be used to correct the errored byte in memory area 15A (with the checksum being recalculated).

Finally, the buffer 13 is cleared and the device reset from its "busy" status (block 54). The firmware update process is then terminated (block 55).

It will be appreciated that the above-described firmware update process ensures that the data storage device is only vulnerable to failures rendering the device becoming inoperable, for a minimum period of time.

Storage of the final checksum in the flash memory 18 enables the microprocessor 17 to run a power-on test for the flash memory 18 in which it recalculates the checksum for the memory and compares it with the value previously calculated and stored in the memory 18.

It will be appreciated that a number of modifications are possible to the described data storage device and its firmware update process. Thus, for example, the new firmware code could be provided on tape and transferred from the tape into the buffer in substantially the same manner as described above for the code provided from the host. Furthermore, the code necessary to control erasure of the flash memory 18 and subsequent transfer of the new firmware code from the buffer memory to the flash memory 18, can be provided with the new firmware code and copied from the buffer 13 into the static RAM 19 rather than using the old code held in the memory 18. Alternatively, the erasure and copying code could simply be stored in a permanent ROM memory.

The firmware code for the microprocessor 17 could also be divided between the two or more memories which may all be flash memories updatable in substantially the manner described above; these memories may be constituted by independently erasable portions of the same flash memory chip. Furthermore, where the control and processing subassembly 16 includes other program-controlled processors (as previously noted) then the microprocessor 17 can be used to run an update process for updating firmware of those other processors where that firmware is held in flash memory.

## Claims

1. A data storage device of the type comprising:
- input/output means (10) for exchanging data between the device and an external data handling system;
- media read/write means (12) for reading/writing data from/to a storage medium;
- a data buffer (13) connected between the input/output means (10) and the media read/write means (12) for buffering the transfer of data between the input/output means (10) and the media read/write means; and
- control and processing means (16)connected to the input/output means (10), the data buffer (13) and the read/write means (12), and operative to control the transfer of data via said data buffer (13) between the input/output means (10) and the read/write means (12) and to process said data, said control and processing means (16) including a non-volatile memory (18) for holding program code and a program-controlled processor (17) operative to execute said program code;
**characterised in that** at least a portion of said non-volatile memory is a flash memory (18) and the control and processing means (16) is operative to implement the following steps in sequence for the purpose of reprogramming the flash memory (18) with new program code:
a) storage of the new program code, received via said input/output means (10) or said media read/write means (12), into said data buffer (13);
b) determination of when all said new program code has been received and stored in the data buffer (13);
c) erasure of said flash memory (18); and
d) transfer of the new program code from said data buffer (13) to said flash memory (18).

2. A data storage device according to claim 1, wherein at least steps c) and d) are implemented by said program-controlled processor (17) under the control of the original said program code, said processor (17) having a further, rewritable, memory (19) associated therewith and the control and processing means (16) being operative in reprogramming the flash memory (18) to copy across from the flash memory (18) to said further memory (19), prior to erasure of the flash memory, that portion of said original program code which corresponds to steps c) and d) and thereafter to execute steps c) and d) by reading the code from said further memory (19).

3. A data storage device according to claim 1, wherein at least steps c) and d) are implemented by said control and processing means (16) under program control, said control and processing means (16) including a further, rewritable, memory (19) and being operative in reprogramming the flash memory (18) to receive and store in said further memory (19), a program for implementing steps c) and d) that is provided via said input/output means (10) or said read/write means (12) along with said new program code, the control and processing means (16) thereafter executing steps c) and d) by reading the said program stored in said further memory (19).

4. A data storage device according to claim 1, wherein following a positive determination in step b) and prior to implementing step c), the control and processing means (16) effects a checking step in which one or more checks are carried out on the new program code, the control and processing means (16) only proceeding with steps c) and d) where the check results are satisfactory.

5. A data storage device according to claim 4, wherein said checking step involves checking the new program code stored in the data buffer (13) to ascertain whether any of the new program code has become corrupted since storage in the data buffer (13).

6. A data storage device according to claim 5, wherein the device is operative during step a):
- to store parity data in respect of each byte or word of the new program code, and
- to generate progressively an error checking code by carrying out an exclusive OR function between each bit of the new program code as it is stored in the data buffer (13) and another bit in said buffer, the resultant error checking code being stored in said buffer;
the device being further operative during said checking step to regenerate said error checking code and said parity data to detect any errors and seek to effect correction of errors so detected.

7. A data storage device according to claim 4, wherein the flash memory (18) holds identification data indicative of the identity of said program code and/or of said device, and wherein the said new program code also includes identification data indicative of the identity of the new program code and/or of the device on which the new program code is intended to run; said control and processing means (16) being operative during the said checking step to compare the identification data held in the flash memory (18) with that provided with the new program code to ascertain whether the new program code is compatible with said device.

8. A data storage device according to claim 4, wherein the flash memory (18) holds device operational parameters, the control and processing means being operative to transfer said device operational parameters to a temporary store (13) prior to implementing step c), and then subsequently to restore said parameters to the flash memory (18).

9. A data storage device according to claim 1, wherein the control and processing means (16) is operative during step a) to calculate a checksum for the area of the buffer used to store the new program code, this checksum being recalculated as new program code is progressively stored in the buffer (13), the final checksum being loaded into the flash memory (18) together with the new program code; the control and processing means (16) being further operative upon power up of the device to recalculate the checksum for the flash memory (18) and compare it with the stored checksum to check the integrity of the program code stored in the flash memory (18).

10. A data storage device according to claim 1, wherein along with the new program code, the device is provided with an indication of the length of the new code, the control and processing means (16) being operative in implementing step b) to utilize this length information to determine when all said new program code has been received.

11. A data storage device according to claim 1, wherein the new program code is provided to said device in encoded form, the control and processing means (16) being operative in implementing step a) to decode the encoded program code and to store decoded code in said buffer (13).

## Patentansprüche

1. Eine Datenspeichervorrichtung des Typs, der folgende Merkmale aufweist:
- eine Eingabe/Ausgabe-Einrichtung (10) zum Austauschen von Daten zwischen der Vorrichtung und einem externen Datenhandhabungssystem;
- eine Medien-Lese/Schreib-Einrichtung (12) zum Lesen/Schreiben von Daten aus/in einem Speichermedium;
- einen Datenpuffer (13), der zwischen die Eingabe/Ausgabe-Einrichtung (10) und die Medien-Lese/Schreib-Einrichtung (12) geschaltet ist, um die Übertragung von Daten zwischen der Eingabe/Ausgabe-Einrichtung (10) und der Medien-Lese/Schreib-Einrichtung zu puffern; und
- eine Steuer- und Verarbeitungs-Einrichtung (16), die mit der Eingabe/Ausgabe-Einrichtung (10), dem Datenpuffer (13) und der Lese/Schreib-Einrichtung (12) verbunden ist und wirksam ist, um die Übertragung von Daten über den Datenpuffer (13) zwischen der Eingabe/Ausgabe-Einrichtung (10) und der Lese/Schreib-Einrichtung (12) zu steuern, und die Daten zu verarbeiten, wobei die Steuer- und Verarbeitungs-Einrichtung (16) einen nicht-flüchtigen Speicher (18) zum Halten des Programmcodes und einen Programm-gesteuerten Prozessor (17), der wirksam ist, um den Programmcode auszuführen, einschließt;
dadurch gekennzeichnet, daß zumindest ein Abschnitt des nicht-flüchtigen Speichers ein Flash-Speicher (18) ist, und die Steuer- und Verarbeitungs-Einrichtung (16) wirksam ist, um die folgenden Schritte der Reihe nach zum Zweck des Umprogrammierens des Flash-Speichers (18) mit einem neuen Programmcode zu implementieren:
a) Speichern des neuen Programmcodes, der über die Eingabe/Ausgabe-Einrichtung (10) oder die Medien-Lese/Schreib-Einrichtung (12) empfangen wurde, in den Datenpuffer (13);
b) Bestimmen, wann der gesamte neue Programmcode empfangen und in dem Datenpuffer (13) gespeichert wurde;
c) Löschen des Flash-Speichers (18); und
d) Übertragen des neuen Programmcodes aus dem Datenpuffer (13) in den Flash-Speicher (18).

2. Eine Datenspeichervorrichtung gemäß Anspruch 1, bei der zumindest die Schritte c) und d) durch den Programmgesteuerten Prozessor (17) unter Steuerung des ursprünglichen Programmcodes implementiert sind, wobei der Prozessor (17) einen weiteren, umschreibbaren Speicher (19), der zu demselben gehört, aufweist, und wobei die Steuer- und Verarbeitungs-Einrichtung (16) beim Umprogrammieren des Flash-Speichers (18) wirksam ist, um vor dem Löschen des Flash-Speichers den Abschnitt des ursprünglichen Programmcodes, der den Schritten c) und d) entspricht, aus dem Flash-Speicher (18) in den weiteren Speicher (19) zu kopieren und danach durch Lesen des Codes aus dem weiteren Speicher (19) die Schritte c) und d) auszuführen.

3. Eine Datenspeichervorrichtung gemäß Anspruch 1, bei der zumindest die Schritte c) und d) durch die Steuer- und Verarbeitungs-Einrichtung (16) unter einer Programmsteuerung implementiert sind, wobei die Steuer- und Verarbeitungs-Einrichtung (16) einen weiteren, umschreibbaren Speicher (19) einschließt und beim Umprogrammieren des Flash-Speichers (18) wirksam ist, um in dem weiteren Speicher (19) ein Programm zum Implementieren der Schritte c) und d) zu empfangen und zu speichern, das über die Eingabe/Ausgabe-Einrichtung (10) oder die Lese/Schreib-Einrichtung (12) zusammen mit dem neuen Programmcode geliefert wird, wobei die Steuer- und Verarbeitungs-Einrichtung (16) danach die Schritte c) und d) durch Lesen des Programms, das in dem weiteren Speicher (19) gespeichert ist, durchführt.

4. Eine Datenspeichervorrichtung gemäß Anspruch 1, bei der nach einer positiven Bestimmung im Schritt b) und vor dem Implementieren des Schritts c) die Steuer- und Verarbeitungs-Einrichtung (16) einen Überprüfungsschritt bewirkt, bei dem eine oder mehrere Überprüfungen auf dem neuen Programmcode durchgeführt werden, wobei die Steuer- und Verarbeitungs-Einrichtung (16) nur mit den Schritten c) und d) fortfährt, wenn die Überprüfungsergebnisse zufriedenstellend sind.

5. Eine Datenspeichervorrichtung gemäß Anspruch 4, bei der der Überprüfungsschritt das Überprüfen des neuen Programmcodes, der in den Datenpuffer (13) gespeichert ist, einschließt, um sicherzustellen, ob ein beliebiger Code des neuen Programmcodes seit der Speicherung in den Datenpuffer (13) verfälscht wurde.

6. Eine Datenspeichervorrichtung gemäß Anspruch 5, bei der die Vorrichtung während des Schritts a) wirksam ist, um:
- Paritätsdaten bezüglich jedes Bytes oder Worts des neuen Programmcodes zu speichern, und
- fortschreitend einen Fehler-Überprüfungscode durch Durchführen einer Exclusiv-ODER-Funktion zwischen jedem Bit des neuen Programmcodes, wie dieser in dem Datenpuffer (13) gespeichert ist, und einem weiteren Bit in dem Puffer durchzuführen, wobei der resultierende Fehlerüberprüfungscode in dem Puffer gespeichert wird;
wobei die Vorrichtung während des Überprüfungsschritts ferner wirksam ist, um den Feherüberprüfungscode und die Paritätsdaten zu regenerieren, um beliebige Fehler zu erfassen und danach zu streben, eine Korrektur der Fehler, die so erfaßt werden, zu bewirken.

7. Eine Datenspeichervorrichtung gemäß Anspruch 4, bei der der Flash-Speicher (18) Identifikationsdaten hält, die die Identität des Programmcodes und/oder der Vorrichtung anzeigen, und bei der der neue Programmcode ebenfalls Identifikationsdaten einschließt, die die Identität des neuen Programmcodes und/oder der Vorrichtung, auf der der neue Programmcode bestimmungsgemäß ausgeführt werden soll, einschließt; wobei die Steuer- und Verarbeitungs-Einrichtung (16) während des Überprüfungsschritts wirksam ist, um die Identifikationsdaten, die in den Flash-Speicher (18) enthalten sind, mit denen zu vergleichen, die mit dem neuen Programmcode bereitgestellt werden, um sicherzustellen, ob der neue Programmcode mit der Vorrichtung kompatibel ist.

8. Eine Datenspeichervorrichtung gemäß Anspruch 4, bei der der Flash-Speicher (18) Betriebsparameter der Vorrichtung hält, wobei die Steuer- und Verarbeitungs-Einrichtung wirksam ist, um die Betriebsparameter vor dem Implementieren des Schritts c) zu einem temporären Speicher (13) zu übertragen und nachfolgend die Parameter in dem Flash-Speicher (18) zu speichern.

9. Eine Datenspeichervorrichtung gemäß Anspruch 1, bei der die Steuer- und Verarbeitungs-Einrichtung (16) während des Schritts a) wirksam ist, um eine Prüfsumme für den Bereich des Puffers zu berechnen, der verwendet ist, um den neuen Programmcode zu speichern, wobei diese Prüfsumme, die als neuer Programmcode neu berechnet ist, fortschreitend in dem Puffer (13) gespeichert wird, wobei die endgültige Prüfsumme zusammen mit dem neuen Programmcode in den Flash-Speicher (18) geladen wird; wobei die Steuer- und Verarbeitungs-Einrichtung (16) beim Anlaufen der Vorrichtung ferner wirksam ist, um die Prüfsumme für den Flash-Speicher (18) neu zu berechnen und dieselbe mit der gespeicherten Prüfsumme zu vergleichen, um die Unversehrtheit des Programmcodes, der in dem Flash-Speicher (18) gespeichert ist, zu überprüfen.

10. Eine Datenspeichervorrichtung gemäß Anspruch 1, bei der der Vorrichtung zusammen mit dem neuen Programmcode eine Anzeige der Länge des neuen Codes bereitgestellt wird, wobei die Steuer- und Verarbeitungs-Einrichtung (16) beim Implementieren des Schritts b) wirksam ist, um diese Längeninformationen zu benutzen, um zu bestimmen, wann der gesamte neue Programmcode empfangen wurde.

11. Eine Datenspeichervorrichtung gemäß Anspruch 1, bei der der neue Programmcode der Vorrichtung in codierter Form bereitgestellt wird, wobei die Steuer- und Verarbeitungs-Einrichtung (16) beim Implementieren des Schritts a) wirksam ist, um den codierten Programmcode zu decodieren und den decodierten Code in dem Puffer (13) zu speichern.

## Revendications

1. Un dispositif de mémorisation de données du type qui comprend:
- un moyen d'entrée/sortie (10) pour échanger des données entre le dispositif et un système externe de traitement de données;
- un moyen de lecture / d'écriture (12) sur un milieu pour lire/écrire des données sur un milieu de mémorisation;
- un tampon (13) de données relié entre le moyen d'entrée/sortie (10) et le moyen de lecture / d'écriture (12) sur le milieu pour entrer en tampon le transfert de données entre le moyen d'entrée/sortie (10) et le moyen de lecture / d'écriture sur le milieu; et
- un moyen de commande et de traitement (16) relié au moyen d'entrée/sortie (10), au tampon (13) de données et au moyen de lecture / d'écriture (12) et exerçant la fonction de commander le transfert de données entre le moyen d'entrée/sortie (10) et le moyen de lecture / d'écriture (12) en passant par le tampon (13) de données et de traiter lesdites données, ledit moyen de commande et de traitement (16) incluant une mémoire non volatile (18) pour retenir un code de programmes et un processeur (17) commandé par programmes qui exerce la fonction d'exécuter ledit code de programmes;
caractérisé en ce qu'au moins une partie de ladite mémoire non volatile est une mémoire flash (16) et le moyen de commande et de traitement (16) exerce la fonction de mettre en oeuvre, en séquence, les étapes suivantes dans le but de reprogrammer la mémoire flash à l'aide du nouveau code de programmes:
a) une mémorisation, dans ledit tampon (13) de données, du nouveau code de programmes reçu par l'intermédiaire dudit moyen d'entrée/sortie (10) ou dudit moyen de lecture / d'écriture (12);
b) une détermination de l'instant où la totalité dudit nouveau code de programmes a été reçue et mémorisée dans ledit tampon (13) de données;
c) un effacement de ladite mémoire flash (18); et
d) un transfert dudit code de programmes depuis ledit tampon (13) de données à ladite mémoire flash (18).

2. Un dispositif de mémorisation de données selon la revendication 1, dans lequel au moins les étapes c) et d) sont mises en oeuvre par ledit processeur (17) commandé par programmes sous la commande dudit code de programmes d'origine, une autre mémoire (19) susceptible d'être récrite étant associée audit processeur et le moyen de commande et de traitement (16) exerçant la fonction de reprogrammer la mémoire flash (18) pour copier, avant l'effacement de la mémoire flash, depuis ladite mémoire (18) vers ladite autre mémoire (19) la partie dudit code de programmes d'origine qui correspond aux étapes c) et d) et pour exécuter ensuite les étapes c) et d) en lisant le code dans ladite autre mémoire (19).

3. Un dispositif de mémorisation de données selon la revendication 1, dans lequel au moins les étapes c) et d) sont mises en oeuvre par ledit moyen de commande et de traitement (16) sous commande d'un programme, ledit moyen de commande et de traitement (16) incluant une autre mémoire (19), susceptible d'être récrite, et exerçant la fonction de reprogrammer la mémoire flash (18) pour recevoir et mémoriser dans ladite autre mémoire (19) un programme de mise en oeuvre des étapes c) et d) qui est fourni en même temps que ledit nouveau code de programmes par l'intermédiaire dudit moyen (10) d'entrée/sortie ou dudit moyen de lecture / d'écriture (12), le moyen de commande et de traitement (16) exécutant ensuite les étapes c) et d) en lisant ledit programme mémorisé dans ladite autre mémoire (19).

4. Un dispositif de mémorisation de données selon la revendication 1, dans lequel le dispositif de commande et de traitement (16) effectue, après une détermination positive à l'étape b) et avant la mise en oeuvre à l'étape c), une étape de vérification dans laquelle une ou plusieurs vérifications sont effectuées sur le nouveau code de programmes, le dispositif de commande et de traitement (16) ne passant aux étapes c) et d) que lorsque les résultats des vérifications sont satisfaisants.

5. Un dispositif de mémorisation de données selon la revendication 4, dans lequel ladite étape de vérification implique de vérifier le nouveau code de programmes mémorisé dans le tampon (13) de données pour établir si une partie quelconque du nouveau code de programmes a été corrompue depuis la mémorisation dans ledit tampon (13) de données.

6. Un dispositif de mémorisation de données selon la revendication 5, dans lequel le dispositif exerce, pendant l'étape a), les fonctions de:
- mémoriser des données de parité concernant chaque octet ou mot du nouveau code de programmes, et
- engendrer progressivement un code de vérification d'erreurs en effectuant une fonction exclusive OU entre chaque bit du nouveau code de programmes au fur et à mesure qu'il est mémorisé dans le tampon (13) de données et un autre but présent dans ledit tampon, le code de vérification d'erreurs qui en résulte étant mémorisé dans ledit tampon;
le dispositif exerçant en outre la fonction de régénérer, pendant ladite étape de vérification, ledit code de vérification d'erreurs et lesdites données de parité afin de détecter toutes erreurs et de chercher à effectuer une correction d'erreurs ainsi détectées.

7. Un dispositif de mémorisation de données selon la revendication 4, dans lequel la mémoire flash (16) retient une donnée d'identification indicative de l'identité du nouveau code de programmes et/ou dudit dispositif, et dans lequel ledit nouveau code de programmes inclut aussi des données d'identification indicatives de l'identité du nouveau code de programmes et/ou du dispositif sur lequel le nouveau code de programmes doit être mis en oeuvre; ledit moyen de commande et de traitement (16) exerçant la fonction de comparer pendant ladite étape de vérification les données d'identification retenues dans la mémoire flash (18) avec celles qui sont envoyées avec le nouveau code de programmes afin d'établir si le nouveau code de programmes est compatible avec le dispositif.

8. Un dispositif de mémorisation de données selon la revendication 4, dans lequel la mémoire flash (18) retient des paramètres opérationnels du dispositif, le moyen de commande et de traitement exerçant la fonction de transférer, avant la mise en oeuvre de l'étape c), lesdits paramètres opérationnels de dispositif à une mémoire temporaire (13) et de restaurer ensuite lesdits paramètres dans la mémoire flash (18).

9. Un dispositif de mémorisation de données selon la revendication 1, dans lequel le moyen de commande et de traitement (16) exerce la fonction de calculer, pendant l'étape a), une somme de vérification pour la zone du tampon qui est utilisée pour mémoriser le nouveau code de programmes, cette somme de vérification étant recalculée au fur et à mesure que le nouveau code de programmes est progressivement mémorisé dans le tampon (13), la somme de vérification finale étant chargée dans la mémoire flash (18) avec le nouveau code de programmes; le moyen de commande et de traitement (16) exerçant en outre la fonction de recalculer, à la mise sous tension du dispositif, la somme de vérification pour la mémoire flash (18) et de la comparer à la somme de vérification mémorisée pour vérifier l'intégrité du code de programmes mémorisé dans la mémoire flash (18).

10. Un dispositif de mémorisation de données selon la revendication 1, dans lequel le dispositif reçoit, avec le nouveau code de programmes, une indication de la longueur du nouveau code, le moyen de commande et de traitement (16) exerçant la fonction de mettre de mettre en oeuvre l'étape b) afin d'utiliser cette information de longueur pour déterminer quand ledit nouveau code de programmes a été reçu en totalité.

11. Un dispositif de mémorisation de données selon la revendication 1, dans lequel le nouveau code de programmes est amené audit dispositif sous forme encodée, le moyen de commande et de traitement (16) exerçant la fonction de décoder, lors de la mise en oeuvre de l'étape a), le code de programmes encodé et de mémoriser le code décodé dans ledit tampon (13).
